# EUROPÄISCHE PATENTSCHRIFT

(11) **EP 1 547 455 B1**
(45) Veröffentlichungstag und Bekanntmachung des Hinweises auf die Patenterteilung: **22.11.2006**
(21) Anmeldenummer: 03750305.9
(22) Anmeldetag: 02.09.2003
(51) Int. Cl.: H05K 7/20

(54) **FLAECHIGES KUEHLAGGREGAT MIT GEGENSTROMKUEHLUNG**
FLAT REFRIGERATING UNIT WITH COUNTER CURRENT COOLING
GROUPE FRIGORIFIQUE PLAT A REFRIGERATION A CONTRE-COURANT

(30) Priorität: 02.09.2002 DE 10240419
(43) Veröffentlichungstag der Anmeldung: 29.06.2005
(73) Patentinhaber: Fraunhofer-Gesellschaft zur Förderung der angewandten Forschung e.V., 80686 München (DE)
(72) Erfinder: PERTHOLD, Rainer, 91085 Weisendorf (DE); ARNETH, Stefan, 91094 Langensendelbach (DE); WILD, Manfred, 92348 Berg (DE); DUERST, Jochen, 96178 Steppach (DE); GERHAEUSER, Heinz, 91344 Waischenfeld (DE)
(74) Vertreter: Leonhard, Frank Reimund
(86) Internationale Anmeldenummer: PCT/DE2003/002904
(87) Internationale Veröffentlichungsnummer: WO 2004/023856

(56) Entgegenhaltungen:
- DE-A- 2 416 471
- DE-U- 9 104 385
- FR-A- 2 078 558
- US-A- 4 949 218

## Beschreibung

Die Erfindung befasst sich mit einem flächigen Kühlaggregat zur Verwendung als Wärmetauscher bei der Kühlung von Luft aus beispielsweise einem Geräteschrank, einem Serverschrank oder einem Schaltschrank, in welchen Wärme erzeugende Einrichtungen eingebaut sind, deren Wärme aus der im wesentlichen geschlossenen Gehäuseanordnung abzuführen ist, um eine Innentemperatur dieser Gehäuse-Anordnungen nicht über einen vorgegebenen Maximalwert steigen zu lassen.

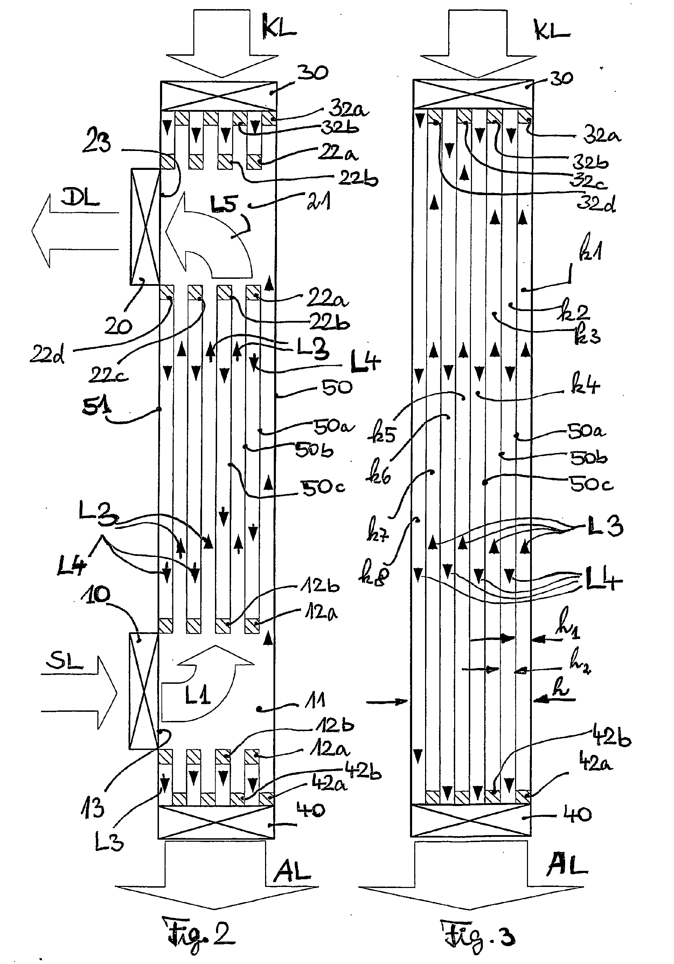

Wärmetauscher im Sinne eines Gegenstromprinzips, bei dem Kühlluft in die eine Richtung strömt und in davon getrennten Strömungskammern die zu kühlende Luft in die andere Richtung strömt, sind als solche schon dem Stand der Technik zuzurechnen, vgl. beispielsweise **DE-A 30 44 135** (Siemens). Dort ist ein Wärmetauscher mit Strömungskanälen beschrieben, die mit ihrem Querschnitt im wesentlichen senkrecht zur Flachseite des Wärmetauschers orientiert sind und längs verlaufen, vgl. dortige Figur 2 sowie hinsichtlich des Gegenstromprinzips die dortige Spalte 6, Zeilen 10 bis 20. Zur Beschickung der so orientierten Kühlkammern mit der zu kühlenden Luft werden Radiallüfter oder Tangentiallüfter eingesetzt, die an den Enden des Wärmetauschers in dreieckförmigen Staukammern eingebaut sind, um die Luft axial anzusaugen und radial in die Staukammern hineinzudrücken (bei der Einströmöffnung für die zu kühlende Luft). Entsprechendes gilt auch am entgegengesetzten Ende bei der Einströmöffnung für die Kühlluft. Sinn und Zweck der beschriebenen Lösung des Standes der Technik ist es, die strömende Luft nahezu gleichmäßig auf alle Strömungskanäle zu verteilen, bei möglichst hoher Ausnutzung des Gehäusevolumens für den Wärmetauscher.

Eine nicht im Gegenstromprinzip arbeitende Tauscheranordnung ist beispielsweise beschrieben in der **DE-A 198 04 904** (Rittal), wo spezifische Stellen im Innenraum, die einer erhöhten Wärmeabgabe unterliegen, mit Schläuchen gesondert gekühlt werden können, wobei diese Kühlschläuche leicht an unterschiedliche Gegebenheiten des Innenraums angepasst werden können (vgl. dort die einzige Figur sowie Spalte 1, Zeilen 54 bis 58.) Ein doppelwandiges Wandelement auf der Schrank(rück)seite sorgt für den Wärmetausch, wobei allerdings kein Gegenstromprinzip eingesetzt wird.

Die Erfindung hat es sich zur Aufgabe gestellt, die Leistungsfähigkeit von Gegenströmüngs-Wärmetauschern weiter zu erhöhen, wobei die Verlustwärme so aus dem Gehäuse oder eventuell einem Gerät, das Schrankgröße besitzt, abgeführt werden soll, dass ein geringerer Anstieg der Innentemperatur pro abgegebenen Watt Verlustleistung in dem Gehäuse oder Schrank entsteht (°K pro Watt oder W/°K).

Gelöst wird die Aufgabe mit einem flächigen Kühlaggregat im Gegenstromprinzip, nach zumindest einem der unabhängigen Ansprüche 1 oder 14.

Anspruch 14 kann die Arbeitsweise von Anspruch 1 sein, Vgl. Anspruch 19.

Die Luft im Innenkreis und im Außenkreis wird genau im Gegenstrom geführt. Damit wird eine maximale Wirksamkeit erreicht. Statt Radiallüftern werden Axiallüfter eingesetzt, deren Leistungsfähigkeit wesentlich höher ist (Anspruch 3) und außerdem weniger Umlenkungen für die zu bewegende (strömende) Luft bereitstellen. Die axial angesaugte Luft wird auch axial abgeführt und im Einlassbereich in den Gegenstrom-Wärmetauscher hineingedrückt, während am Auslassbereich ebenfalls ein solcher Axiallüfter - beabstandet von dem Eingangsbereich - angeordnet sein kann, der die dann gekühlte Luft aus dem Wärmetauscher herauszieht und zurück in den Schaltschrank, Serverschrank oder Geräteschrank oder ein einzelnes großes Gerät hineinbringt (Anspruch 1, 14). Günstig für die Erhöhung des Wärmetauschs ist dabei ein Unterschied in der Leistungsfähigkeit, der eingestellten Drehzahl oder der Größe der beiden Lüfter, die den zu kühlenden Luftstrom verursachen. Der Lüfter an dem Einlassbereich soll mit einer größeren Leistung betrieben werden, betreibbar sein oder mit einer höheren Drehzahl betrieben werden, als derjenige am Auslassbereich. Hinsichtlich der Kühlluft, die von ebenfalls zwei Axiallüftern im Gegenstromprinzip bereitgestellt wird, ist es günstig, wenn diese beiden Lüfter am Einlassbereich der Kühlluft und am Auslassbereich der Kühlluft (der Abluft) im wesentlichen die gleiche Leistungsfähigkeit, Drehzahl oder Leistungseinstellung besitzen. Trotz Bereitstellung einer maximal möglichen kühlenden Luft wird durch das erhöhte Einbringen der zu kühlenden Luft eine längere Verweildauer der zu kühlenden Luft erreicht und - nach derzeitigem Wissensstand - auch die Verwirbelung oder die Turbulenzen innerhalb der Strömungskammern erhöht, was zu einem verbesserten Wärmetausch mit der entgegenströmenden Kühlluft führt.

Der Strömungsweg der Kühlluft ist dabei praktisch geradlinig (Anspruch 1). Zwischen dem Ausgang des ersten Lüfters und des zweiten Lüfters verläuft der Weg der Kühlluft praktisch geradlinig durch die Kammern, lediglich unterbrochen von dem Einströmbereich und dem Ausströmbereich der zu kühlenden Luft, die in keinem physischen Kontakt mit der Kühlluft steht, sondern durch getrennte Kammern im

Gegenstromprinzip geleitet wird (Anspruch 14).

Statt einem Lüfter können auch mehrere Lüfter jeweils parallel geschaltet sein, je nach Ausbildung, Form und Größe des flächigen Kühlaggregats (Anspruch 3).

Die U-förmige Ausbildung des Strömungsweges für die zu kühlende Luft hat sich als insoweit günstig erwiesen, als diese Luft möglichst wenig Umlenkungen während ihres Strömungsweges erfährt, wobei die Axiallüfter einen Beitrag leisten. Ausgehend von einem Einlassbereich, insbesondere in zylindrischer Gestaltung, wird Luft in eine erste Staukammer gedrückt, die unter Überdruck durch Wirkung des ersten Lüfters steht. Von dieser Staukammer wird die Luft auf eine Vielzahl paralleler Flächenkammern verteilt, die sich flächig parallel zur Flachseite des Wärmetauschers erstrecken. Am Auslassbereich, der in einem deutlichen Abstand vom Einlassbereich im wesentlichen senkrecht zur Flachseite des Wärmetauschers orientiert angeordnet ist, sammelt sich die gekühlte Luft aus den einzelnen, parallelen und beabstandeten Flächenkammern wieder in einem im wesentlichen zylindrischen Sammelraum, aus dem sie als gekühlte Luft in den Bereich zurückgegeben wird, in welchem die Wärme entsteht. An dieser Stelle kann ein weiterer (in den Ansprüchen als vierter Lüfter bezeichneter) Axiallüfter angeordnet werden, der die Luft aus dem Sammelraum abzieht, bevorzugt aber mit einer geringeren Leistung, als demjenigen ersten Lüfter, der die Luft in den ersten Stauraum einbringt (Ansprüche 11,12,18).

Mit einer solchen Gestaltung ist es möglich, die verfügbare Baulänge und somit auch die Fläche für das zum Wärmetausch verwendete Blechpaket vollständig auszunutzen und im Bleckpaket selbst keine Räume freizustellen oder aussparen zu müssen, die einen Lüfter aufnehmen. Dazuhin ergibt sich durch die Lage und Bauhöhe der flachen Strömungskanäle eine turbulente, verwirbelnde Strömung, die bevorzugt mit an der Oberfläche nicht ebenen Platten (Anspruch 6) eine erhöhte Tauscherleistung zur Verfügung stellt.

Die als flächige Kammern bezeichneten Strömungskammern für die zu kühlende Luft und auch für die Kühlluft haben bezogen auf ihre Breite und Länge eine nur geringe Höhe. Breite und Höhe ist hier so zu verstehen, dass diese beiden Maße eine Ebene parallel zur Flachseite des Wärmetauschers beschreiben, während die Höhe in Richtung der Dicke, also senkrecht zur flächigen Erstreckung des flachen Kühlaggregats definiert ist (Anspr. 16, 17).

Die Tauscherleistung wird auch dadurch erhöht, dass der Gegenstromaustausch nicht erst nach dem Einlass und bis hin zum Auslass der zu kühlenden Luft erfolgt, sondern auch darüber hinaus, also dem Auslass nachgelagert und dem Einlass vorgelagert (Anspruch 15).

Die insoweit im Gegenstromprinzip abwechselnd angeordneten flächigen Strömungskammern für Kühlluft und zu kühlende Luft erstrecken sich auch zwischen dem Ausströmende des Wärmetauschers und dem Einlassbereich sowie zwischen dem Einströmbereich der Kühlluft und dem Auslassbereich der zu kühlenden Luft, die hier bereits als die "gekühlte Luft" bezeichnet wird.

Zur Terminologie sei angemerkt, dass die "zu kühlende Luft" als diejenige Luft beschrieben wird, die als Brauchluft innerhalb des Schranksystems umgewälzt und dabei gekühlt wird. Sie hat an ihrem Austritt die niedrigst mögliche Temperatur und wird hier als gekühlte Luft bezeichnet, oft aber auch - zur Darstellung des Kreislaufes - im Zuge ihres Gesamtverlaufes als zu kühlende Luft. Die Nutzluft, mit welcher der Wärmetauscher gekühlt wird, wird als Kühlluft bezeichnet, die im Auslassbereich, also dort, wo sie ihre maximale Temperatur besitzt, als Abluft benannt wird. Dennoch bleibt die Kühlluft auch während ihrer gesamten Strömungsstrecke im Tauscher als solche benannt, um eine sinngemäß einheitliche Terminologie für die zu beschreibende Erfindung zu erhalten.

Auch anzumerken ist, dass bei der Umschreibung eines flächigen Kühlaggregats die Funktion und Wirkungsweise dieses Aggregats oft durch Verwendung der Luftströmungen und der strömenden Luft beschrieben wird, was aber nicht insoweit einschränkend verstanden werden soll, als dass damit nur der aktuelle Betrieb gemeint ist. Der aktuelle Betrieb ist vielmehr von einem Verfahrensanspruch (Anspruch 14) umfasst, mit welchem erläutert wird, dass der Einlassbereich und der Auslassbereich der zu kühlenden Luft nicht die Enden des jeweiligen Wärmetauschers sind, sondern zwischen diesen Bereichen und dem jeweiligen stirnseitigen Ende (Anfang) auch noch Kühlbereiche im Gegenstromprinzip platziert sind. Das wird so umschrieben, dass an dem Einlassbereich vorbei kühlende Kühlluft noch zu strömen vermag, alternativ oder kumulativ auch hinter dem Auslassbereich der gekühlten Luft noch kühlende Frischluft im Gegenstrom-Wärmetauschprinzip eingesetzt werden kann.

Wenn die Kühlluft am Einlassbereich der zu kühlenden Luft noch vorbeiströmt und die kühlende Luft schon vor dem Auslassbereich strömt (Anspruch 15) ist dies in den Bereichen von Einlass und Auslass (der zu kühlenden Luft) jeweils so vorgesehen, dass es auf einer Breite erfolgt, die nicht geringer ist, als diejenige Breite, insbesondere der Durchmesser, des Einströmbereichs oder des Ausströmbereichs selber.

Aus der Höhe der strömenden Luftschichten (Anspruch 17) ist auch auf den Abstand der die Kammern trennenden metallischen Bleche zu schließen (Anspruch 17). Letztere Kammern sind mit Trennelementen in Form von Stegen so abgedichtet, dass jeweils ein getrenntes Kammersystem für die kühlende Luft und ein getrenntes Kammersystem für die zu kühlende Luft entsteht, die sich abwechseln (Ansprüche 6, Ziffer (a), 2, 4, 5 sowie 13).

Eine weitere Erhöhung der Kühlleistung oder der Wärmeabgabeleistung im Wärmetauscher erreicht man mit Sperrstücken (Anspruch 7), welche einen direkten (kurzen) Strömungsweg für die zu kühlende Luft sperren und diese Luft zur Begünstigung einer Verwirbelung oder einer turbulenten Strömung aus dem kürzesten Strömungsweg ablenken und in einen längeren Strömungsweg zwingen. Diese Sperrstücke können als Bogenstücke ausgebildet sein, insbesondere verstellbar (Anspruch 8,9). Sie sind im Einlassbereich und im Auslassbereich angeordnet, bevorzugt gegenüberliegend.

Die Erfindung erreicht es, mit solwenig rechtwinkligen Umlenkungen wie möglich die Gegenstrom-Strömungsleistung zu sichern und dabei die verfügbaren Kammern so vollständig und so gleichmäßig wie möglich auszunutzen. In technischen Versuchen konnte erprobt werden, dass ein Wärmetauscher eine mehr als doppelt so große Kühlleistung erzielte, als derzeit verfügbare Luft-Wärmetauscher im Gegenstromprinzip. Erreicht wurden Werte von oberhalb 400 W/°K, die bei einer Größenordnung des Wärmetauschers mit Außenabmessungen von 100cm Länge, 40cm Breite und 18cm Höhe (Dicke/Stärke) erreicht wurde.

Die Erfindung wird im folgenden an Ausführungsbeispielen erläutert und ergänzt.
- **Figur 1**: ist eine Ansicht auf die Flachseite 51 eines Wärmetauschers mit einer Einströmöffnung 13 und einer Ausströmöffnung 23 für die zu kühlende Luft bzw. die gekühlte Luft. Zwei Schnittlinien A und B sind angedeutet.
- **Figur 2**: ist ein Querschnitt entlang der Ebene A von Figur 1.
- **Figur 3**: ist ein Querschnitt entlang der Ebene B von Figur 1.
- **Figur 4**: veranschaulicht eine vorteilhafte Ergänzung der Anordnung nach Figur 1, wobei die Querschnitte der Figuren 2 und 3 entsprechend auch für diese Anordnung gelten, mit den entsprechenden Abschnitten 18, 28, die in den Figuren 2 und 3 nicht eingezeichnet sind.

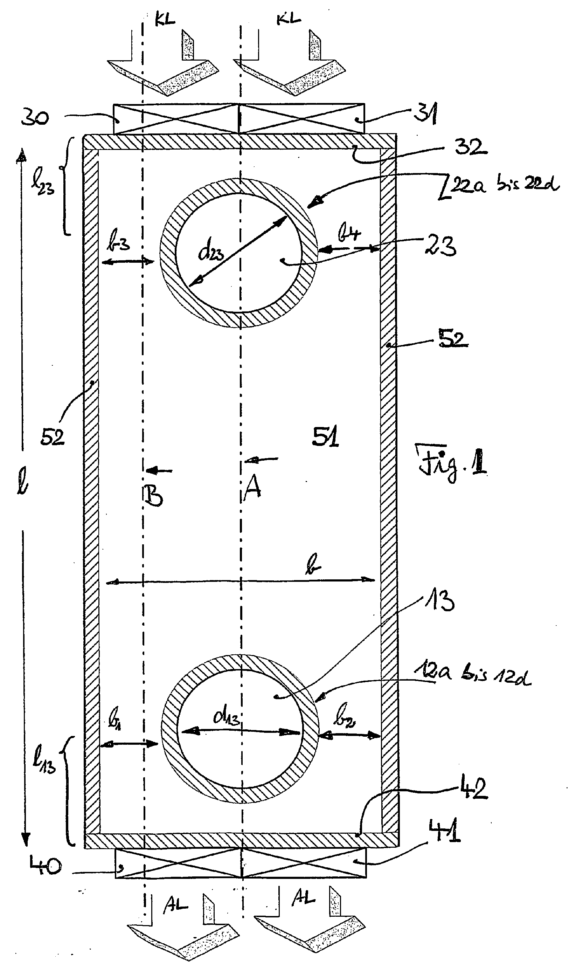

**Figur 1** veranschaulicht eine Aufsicht auf die Flachseite 51 des flächigen Kühlaggregats. In der Flachseite 51 sind zwei Aussparungen 13, 23 vorgesehen, die im wesentlichen entlang einer Mittelebene A ausgerichtet sind, aber einen deutlichen Abstand in Längenrichtung I des flächigen Kühlaggregats besitzen. Sie sind jeweils in einem Abstand I₂₃, I₁₃ ihrer jeweiligen Mitten von dem oberen und unteren Stirnende des flächigen Kühlaggregats in der vorderen Flachseite 51 angeordnet. Die Aussparungen 23, 13 sind kreisförmig und im Querschnitt entlang der Ebene A erstrecken sich zylindrische Räume in die Tiefe h des Kühlaggregats, vgl. **Figur 2**. Die Breite des Kühlaggregats erstreckt sich senkrecht zur Länge und ist mit b in Figur 1 bezeichnet. Der Kühlkörper ist wesentlich länger, als er breit ist. Die Tiefe (Dicke oder Stärke) in Richtung h ist wiederum wesentlich geringer, als die Breite. Die Tiefe kann aber auch deutlich erhöht werden, wenn mehrere der später zu beschreibenden Blechwände 50a, 50b, 50c zur Definition der Strömungskammern k1, k2, k3,... verwendet werden.

Bei Zugrundelegung einer kreisförmigen Öffnung 13 für den Eintritt der zu kühlenden Warmluft und einer kreisförmigen Öffnung 23 für den Austritt der gekühlten Warmluft bzw. der in den Schaltschrank zurückkehrenden Kaltluft, sind der Stauraum 11 hinter dem Eintritt 13 und der Sammelraum 21 vor dem Austritt 23 jeweils zylindrisch. Diese Bereiche werden auch als Eintrittsbereich und Austrittsbereich bezeichnet. Vor dem Eintrittsbereich 13 ist ein erster Axiallüfter 10 angeordnet, der die zu kühlende warme Luft SL (Saugluft) in einem Luftstrom in die erste Staukammer 11 hineindrückt. Ein zweiter Lüfter 20 kann an der Austrittsöffnung 23 angeordnet sein, um gekühlte Luft aus der Sammelkammer 21 aufzunehmen und als Druckluft DL in den Kreislauf zurückzugeben.

Die Flachseite 51 von Figur 1 wird als eine oder an eine Wand eines Schrankgehäuses, beispielsweise eines Geräteschrankes, eines Serverschrankes oder eines Schaltschrankes mit entsprechenden Öffnungen montiert, so beispielsweise die Tür, eine Seitenwand oder die Rückwand. Dadurch haben die Öffnungen 13, 23 Zutritt zu dem Inneren des Schrankes, der im übrigen geschlossen sein kann und meist auch geschlossen sein wird. Es entsteht dann eine Umwälzung des warmen Luftvolumens im Schrank durch den Wärmetauscher hindurch, der seinerseits durch Kühlluft KL im Gegenstromprinzip eine Kühlung der zirkulierten Schrankluft verursacht, welche Kühlluft als Abluft AL am entgegengesetzten Stirnende wieder austritt.

Dieser Durchfluß der kühlenden Luft KL, L4, AL erfolgt entlang von Strömungskammern, die im Schnitt später erläutert werden.

Der Luftstrom zum Kühlen ist schematisch durch Pfeile in Figur 1 veranschaulicht. Er wird unterstützt durch hier eingezeichnete zwei Eingangslüfter 30, 31, die benachbart angeordnet und elektrisch parallel geschaltet sind. Ebenfalls benachbart angeordnet und elektrisch ebenfalls parallel geschaltet sind zwei Ausgangslüfter 40, 41, alles Lüfter nach dem Prinzip der Axiallüftung, also mit einer Drehachse und einem Innenträger, an dem radiale Flügel angeordnet sind, welche die Luft komprimieren und fördern. Luft tritt hierbei axial ein und axial aus, wobei das Ende der Eingangslüfter 30, 31 den Beginn des Wärmetauschers definiert und der Beginn der Austrittslüfter 40, 41 das Ende des Wärmetauschers.

Nachdem die Öffnungen 13, 23 im Abstand vom unteren Ende und vom oberen Ende angeordnet sind, besitzen sie auch einen Abstand b1, b2 bzw. b3, b4 von dem lateralen Längsseiten (Schmalseiten) des Wärmetauschers. Der Einströmbereich 13 und der Ausströmbereich 23 sind damit so in dem Wärmetauscher plaziert, daß - in Strömungsrichtung der kühlenden Luft KL gesehen - eine Tauscherfläche auch vor dem Austrittsbereich 23 und nach dem Eintrittsbereich 13 angetroffen wird. Auch neben dem Austrittsbereich und neben dem Eintrittsbereich sind Tauscherflächen vorgesehen, so daß ein Umspülen der hier zylindrisch ausgeformten Sammelkammer bzw. Staukammer 21, 11 möglich ist.

Die Strömungsbreiten b1, b2 sowie b3, b4 sollten jeweils zusammengenommen zumindest in der Größenordnung des Durchmessers d13 und d23 der Öffnung 13, 23 liegen, können bevorzugt aber auch größer ausgestaltet sein. Die Anzahl der Axiallüfter 30, 31, 40, 41 auf der Eingangsstirnseite und der Ausgangsstirnseite des flächigen Kühlaggregats hängt von dessen Abmessungen ab. Es können ebenso mehrere Axiallüfter parallel geschaltet sein, wie auch weniger.

An den Längs-Stirnseiten ist der Wärmetauscher geschlossen, was durch einen Stapel von Stegen 52 erreicht wird, welche die einzelnen Kammern zwischen der hinteren Rückwand 50 und der in Figur 1 sichtbaren Frontwand 51 vollständig abdichten. Im oberen Stirnbereich sind ebenfalls Abdichtungsstege 32a, 32b, 32c,... vorgesehen, die aber nur jede zweite Kammer zur Außenseite hin abdichten, wie auch im unteren Stirnbereich nahe den Lüftern 40,41 nur jede zweite Kammer mit Stegen 42a, 42b, 42c, kurz 42 zur Außenseite hin abgedichtet sind. Diejenigen Kammern, die stirnseitig mit den Stegen 32 bzw. 42 abgedichtet sind, sind dieselben Kammern, bzw. die Stege 32, 42 befinden sich auf derselben Ebenenhöhe, bezogen auf die Flachseite 51.

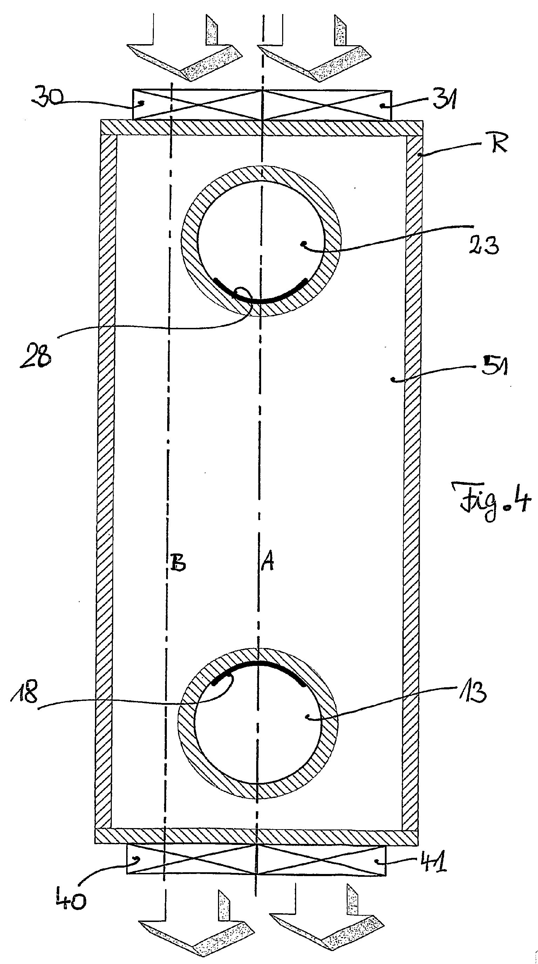

Diese Orientierung der Strömungskammern veranschaulichen die beiden Schnitte entlang den Ebenen A und B, wobei der Schnitt entlang der Ebene A die Staukammer und die Sammelkammer 11, 21 mit veranschaulicht, während die Schnittdarstellung der **Figur 3** entlang der Ebene B den gesamten Strömungsweg veranschaulicht, an dem ersichtlich ist, daß die Stege 32 und die Stege 42 jeweils dieselbe Kammer stirnseitig (zum Außenraum hin) abdichten. Diese flächigen Strömungskammern k1, k3, k5, k7 sind diejenigen Strömungskammern (mit ungeraden Indizes), welche die aufwärts strömende, zu kühlende Warmluft L3 aufnehmen. Sie stammt aus der Staukammer 11 als Folge des Lüfterdrucks aus der Saugluft SL zum Luftstrom L1 und enden in der Sammelkammer 21, umgelenkt entlang des Strömungsweges L5 und angesaugt von dem Axiallüfter 20 zur Bildung von Druckluft DL am Ausgang des zweiten Axiallüfters 20.

Die in Figur 3 mit der Außenluft in Verbindung stehenden Strömungskammern k2, k4, k6, k8 sind diejenigen Strömungskammern, welche die kühlende Außenluft L4 aufnehmen und im Gegenstromprinzip zu dem Luftstrom L3 in den anderen Kammern mit den ungeraden k-Indizes führen. Sie sind nicht an den Stirnseiten mit Stegen verschlossen, sondern in den Bereichen der Einströmung 13 und der Ausströmung 23 für die zu kühlende (erwärmte) Luft. Die hier gebildeten Stege 22a, 22b, 22c, (kurz 22) und 12a, 12b, 12c (kurz 12) schließen die Strömungsräume der Außenluft gegenüber der Innenluft dicht ab. Diese Stege sind in der Aufsicht von Figur 1 um den Einlaß 13 herum und um den Auslaß 23 herum schematisch ersichtlich. Sie sorgen ebenso wie die Stege 32, 42 für eine physische Trennung der langgestreckten, flächigen Strömungskammern, die die Außenluft führen und denjenigen anderen parallelen Strömungskammern, welche die Innenluft führen.

Das Prinzip des Gegenstroms ist anhand der Figur 2 und 3 ersichtlich. Die Stapelung der einzelnen flächigen Strömungskammern ebenfalls und die flächige Erstreckung dieser flächigen Strömungskammern veranschaulicht die Figur 1, wobei sich jede Strömungskammer zwischen den stirnseitigen, Längsseiten 52, den stirnseitigen Schmalseiten 32, 42 und den Stegen 12 und 22 um Einlaßbereich und Auslaßbereich herum erstreckt. Die flächige Erstreckung der Kammern ist damit in ihrer Breiten- und Längsrichtung wesentlich größer, als die Höhe h jeder der Kammern, wobei die Höhe mit h1 für die Kammer k1 und die Höhe h2 für die Kammer k2 in Figur 3 angegeben ist. Die anderen Höhen der anderen Kammern sind entsprechend.

Alle Kammern haben bei gleicher Steghöhe praktisch die gleichen Höhen (Dicken oder Stärken) wobei einzelne Blechlagen 50a, 50b, 50c jede der Kammern flächig begrenzt. Die Blechlagen können zusätzlich senkrecht zu ihrer Erstreckung uneben ausgestaltet sein, beispielsweise durch Wellung oder eingeprägte Noppen, um die Wärmetauscherfläche zwischen den Kammern zu vergrößern. Sie sind für die Luftströmung aber undurchlässig, um die kühlende Luft von der zu kühlenden Luft physisch zu trennen.

In einer beispielhaften Realisierung betrugen die Kammerhöhen weniger als 10 mm, bevorzugt weniger als 5 mm. Die Stege 12, 42 sowie 22, 32 sind im Beispiel mit den Blechen 50a, 50b, 50c, etc. verklebt, um einen luftdichten Abschluß zu erreichen. Ebenso können die gestapelten Stege 52 im stirnseitigen Längsbereich mit den Blechen im Randbereich verklebt sein, zusätzlich durch eine Schraubbefestigung auch noch verstärkt werden.

Bei einer Ausbildung des Wärmetauschers so, wie in **Figur 4** abgebildet, ergänzt sich am unteren Ende der Auslaßöffnung 23 und am oberen Ende der Einlaßöffnung 13 ein jeweiliges bogenförmig gestaltetes Abdeckblech 18, 28 als Strömungssperre. Sie kann sich ganz in die Tiefe des Stauraums 11 und in die Tiefe des Sammelraums 21 erstrecken. Im übrigen ist der Wärmetauscher von Figur 4 in der Ebene B so ausgebildet, wie anhand der Figuren 1 bis 3 beschrieben. Eine Schnittdarstellung des Wärmetauscher von Figur 4 würde genau derjenigen Schnittdarstellung von Figur 3 entsprechen, bei gleichem Gegenstromprinzip und gleicher Kammerhöhe der flächigen Strömungskammern. In der Figur 2 würde im Bereich des Austritts der zu kühlenden Luft L3 aus den Strömungskammern nahe den unteren Abschnitten der Stege 22a, 22b und unterhalb der oberen Stegabschnitte Stege 12a, 12b beim Eintritt des Luftstroms L1 in die Strömungskammer eine Abdeckung erfolgen, die aber nicht die gesamte Breite der flächigen Strömungskammern erreicht. Die Strömung L1 würde dann zunächst abgelenkt in die Seitenbereiche der Abschnitte b1, b2 am Einlaß und dann entlang des flächigen Mittelabschnitts des Strömungstauschers entlanggeführt werden. Eine dadurch entstehende zusätzliche Verwirbelung sorgt für eine Verstärkung des turbulenten Strömungseffektes und damit für eine stärkere Wärmetauschwirkung und höhere Wärmeübertragungs-Leistung an die entgegenströmende Kühlluft L4.

Die Abstimmung der elektrischen Leistungen der Lüfter, oder aber ihrer Größen oder aber ihrer tatsächlich betriebenen Drehzahl sollte bevorzugt so erfolgen, daß der Lüfter 10 mit einer größeren Leistung betrieben wird, als der Lüfter 20. Die Staukammer 11 erhält so einen stärkeren Überdruck, als er von der Sammelkammer 21 aus durch deren Unterdruck reduziert werden kann. Auch diese technische Gestaltung oder dieser technische Betrieb des Wärmetauschers sorgen für eine stärkere Verwirbelung und eine Erhöhung des Turbulenzeffektes in den flachen Strömungskammern. Die verschiedenen Maßnahmen zur Veränderung der Leistung des unteren Lüfters sind alternativ möglich. Es können unterschiedliche Lüftertypen (nach Baugröße) hinsichtlich der Lüfter 10. oder 20 verwendet werden. Es können dieselben Lüfter verwendet werden, die unterschiedlich betrieben werden und es können unterschiedliche Lüfter verwendet werden, die unterschiedlich betrieben werden, aber nach der gleichen beschriebenen Maßgabe.

Die Lüfter 30, 31 und 40, 41 sollten dagegen im wesentlichen gleich stark sein, also gleichen Luftdurchsatz zu erreichen.

Die mit der beschriebenen Anordnung erreichten Kühlungswirkungen konnten um 20 % bis 30 % erhöht werden, wenn die Ablenkfläche oder Leitfläche im Sinne von Sperrstücken 18, 28 zu der ohnehin schon in der Wärmetauschleistung hervorragenden Ausführungsform von Figur 1 hinzugenommen wurde. Die Verweildauer der zu kühlenden Luft in den langgestreckten Flachkammern wird dabei zusätzlich zu der Erhöhung der Verwirbelung erreicht. Der kürzeste Weg, also der Kurzschluß für die im U-förmigen Bewegungsstrom geleitete Luft SL, L3, DL wird gesperrt und trotz Beibehaltung der im wesentlichen U-förmigen Strömungsrichtung werden die lateralen Abschnitte b3, b4, b1, b2 neben der Einströmungsöffnung 13 und neben der Ausströmungsöffnung 23 an dem Wärmetausch beteiligt, was auch für den vorderen Abschnitt I₂₃ und den hinteren Abschnitt I₁₃ des Wärmetauschers gilt, bezogen auf die Strömungsrichtung der äußeren Kühlluft KL, AL. Um die Einlaßöffnung herum (außerhalb der abdichtenden Stege 12, und/oder um die Auslaßöffnung 23 herum (um die hier abdichtenden Stege 22) kann die äußere Kühlluft ihre Kühlungswirkung entfalten. Während des im wesentlichen linearen Durchtritts durch die zugehörigen Flachkanäle k2, k4, k8 kann ein Umspülen des Einströmbereiches und des Ausströmbereiches erreicht werden. Die Umspülung kann beeinflußt werden, wenn die bogenförmigen Sperrstücke 18, 28 verstellt werden, welche Verstellung sowohl in umfänglicher Richtung orientiert sein kann, wie auch in axialer Richtung durch Hereinschieben und Herausnehmen aus der zylindrischen Staukammer 11 bzw. der zylindrischen Aufnahmekammer 21.

Die Form der Kammern 11, 21 ist nicht auf eine zylindrische Gestalt beschränkt, vielmehr können auch im näheren Umfeld abweichende Geometrien gewählt werden, wie Ellipsen und Mehrecke. Vorteilhaft ist es aber, wenn sich die Kammer bis ganz in die Tiefe des Wärmetauschers erstreckt und die gesamte Höhe h des flächigen Kühlaggregats einnehmen.

## Patentansprüche

1. Flächiges Kühlaggregat zur Verwendung für Geräte-, Server- oder Schaltschränke oder eine im wesentlichen geschlossene Gehäuseanordnung zur Aufnahme von Wärme erzeugenden Einrichtungen, wobei erwärmte Luft (SL) - im Gegenstrom (L4;L3;k₁;k_{2...}) mit entgegen strömender Kühlluft (KL) - in ihrer Temperatur herabsetzbar ist, ohne dass sich die Kühlluft mit dem erwärmten - zu kühlenden - Luftstrom (L1,L3,L5) im flächigen Kühlaggregat physisch berührt; **dadurch gekennzeichnet, dass**
(a) in einem Einströmbereich (13,11) und/oder in einem Ausströmbereich (23,21) für die zu kühlende Luft dichtende Trennelemente (12a,12b,12c;22a,22b,22c) vorgesehen sind, mit welchen erste Kanäle (k1,k3,k5) für die zu kühlende Luft (L3) von zweiten Kanälen (k2,k4,k6) für die kühlende Luft (L4) getrennt sind;
(b) die den Einströmbereich (11) oder Ausströmbereich (21) der zu kühlenden Luft (L3) gegen die kühlende Luft (L4) abdichtenden Trennelemente (12a,22a,...) im Kühlaggregat angeordnet sind und vom Luftstrom der kühlenden Luft und der zu kühlenden Luft vollständig umspülbar sind, womit eine Tauscherfläche auch vor dem Einströmbereich und nach dem Ausströmbereich vorgesehen ist oder wird.

2. Kühlaggregat nach vorigem Anspruch, wobei Stege zum Abschließen einer jeweiligen Kammer so angeordnet sind, dass sie Flächenkammern für die zu kühlende Luft an einer Einströmseite (30) und Ausströmseite (40) der Kühlluft dicht abschließen und die flächigen Kammern für die Kühlluft (KL,L4,AL) bei dem Einströmbereich und dem Ausströmbereich für die zu kühlende Luft (11,21) dicht abschließen.

3. Kühlaggregat nach einem der vorigen Ansprüche, wobei zwei Lüfter (30,31; 40,41,10) als Axiallüfter ausgebildet sind.

4. Kühlaggregat nach einem der vorigen Ansprüche 2 oder 3, wobei die Kammern (k1,k2,k3,k4) durch Bleche (50a,50b,50c...) voneinander getrennt sind und durch einen Abstand der Bleche die Höhen (h1,h2,...) der Kammern gebildet sind.

5. Kühlaggregat nach einem der vorigen Ansprüche, wobei an dem Einlassbereich und dem Auslassbereich (13,23) sowohl der kühlenden wie auch der zu kühlenden Luft Stegstücke (12,42,22,32) zwischen die Kammern flächig begrenzenden Blechen (50a,50b) bzw. zum Schließen der an der jeweiligen Stelle nicht offenen Kammer vorgesehen sind.

6. Kühlaggregat nach Anspruch 4 oder 5, wobei die Bleche nicht eben, insbesondere gewellt oder genoppt sind.

7. Kühlaggregat nach einem voriger Ansprüche, wobei im Einlassbereich der zu kühlenden Luft (SL) und/oder im Auslassbereich der gekühlten Luft (DL) Sperrstücke (28, 18) vorgesehen sind, um einen direkten Strömungsweg zwischen dem Einlassbereich und dem Auslassbereich zu sperren und den Weg der zu kühlenden Luft in den Kammern zu verlängern.

8. Kühlaggregat nach Anspruch 7, wobei die Sperrstücke (18,28) verstellbar sind.

9. Kühlaggregat nach Anspruch 7 oder 8, wobei die Sperrstücke gebogen ausgebildet sind.

10. Kühlaggregat nach einem voriger Ansprüche, wobei der Einlassbereich (13,11) und/oder der Auslassbereich (23,21) im Wesentlichen rund bzw. in einer Höhenerstreckung (h) des Kühlaggregats im Wesentlichen zylindrisch ausgestaltet sind.

11. Kühlaggregat nach einem voriger Ansprüche, wobei ein dritter Lüfter (10) am Einlassbereich (13,11) der zu kühlenden Luft (SL) mit einer Drehzahl betreibbar ist, welche größer ist als eine Drehzahl eines vierten Lüfters (20) am Auslassbereich der gekühlten Luft (DL,23), insbesondere oberhalb von 10 % der Leistung des vierten Lüfters (20).

12. Kühlaggregat nach einem der vorigen Ansprüche 1 bis 10, wobei ein vierter Lüfter am Auslassbereich (21,23) der gekühlten Luft angeordnet ist, welcher schwächer ist, als ein dritter Lüfter (10).

13. Kühlaggregat nach Anspruch 4, wobei der Abstand der Bleche durch Stege (12a,42a,22a,32a) festgelegt ist und die Höhe (h1,h2) einer jeweiligen Kammer der Steghöhe entspricht.

14. Verfahren zur Kühlung von Luft aus einem Geräte-, Server- oder Schaltschrank oder einer im wesentlichen geschlossenen Gehäuseanordnung zur Aufnahme von Wärme erzeugenden Einrichtungen, wobei erwärmte Luft (SL) - im Gegenstrom (L4;L3;k₁;k_{2...}) mit entgegen strömender Kühlluft (KL) - in ihrer Temperatur herabgesetzt wird, ohne dass sich die Kühlluft mit dem erwärmten - zu kühlenden - Luftstrom (L1,L3,L5) physisch berührt;
**dadurch gekennzeichnet, dass** vorbei an einem zylindrischen Einlassbereich (13,11) für den zu kühlenden Luftstrom (SL,L1) und/oder vor einem zylindrischen Auslassbereich (21, 23) für den bereits vor und nach dem Einlass/Auslass gekühlten Luftstrom (L5, DL) die Kühlluft (KL,AL) strömt, um Tauscherfläche nach oder vor dem Einlass bzw. Auslass zu haben.

15. Verfahren nach Anspruch 14, wobei das Vorbeiströmen am Einlassbereich bzw. das Strömen vor dem Auslassbereich auf einer Breite (b1+b2; b3+b4) erfolgt, welche nicht geringer ist, insbesondere im wesentlichen gleich oder größer ist, als eine Breite, insbesondere ein Durchmesser (d₁₃, d₂₃) des Einströmbereichs (13) oder des Ausströmbereichs (23).

16. Verfahren nach Anspruch 14, wobei die zu kühlende und die kühlende Luft (L3,L4) in flächig ausgedehnten Schichten strömt, welche eine nur solche Höhe (h1,h2) aufweisen, um eine turbulente Strömung in den Schichten zu begünstigen.

17. Verfahren nach Anspruch 16, wobei die Schichten unter 10mm, insbesondere unter 5mm hoch sind.

18. Verfahren nach Anspruch 14, wobei die mit einem dritten Lüfter (10) zugeführte erwärmte Luft (SL) intensiver, insbesondere mit größerer Leistung zugeführt wird, als diejenige eines vierten Lüfters (20), der die im Kühlaggregat gekühlte Luft im Auslassbereich (23, 21) aus dem Kühlaggregat abzieht.

19. Verfahren nach Anspruch 14, wobei ein Kühlaggregat nach Anspruch 6 verwendet wird.

## Claims

1. A thin cooling unit of use for instrument lockers, server cabinets or switch cabinets or a substantially closed casing arrangement for holding heat-generating devices, wherein heated air (SL) can be reduced in temperature in counter-current (L4; L3; k₁; k₂, ...) with cooling air (KL) flowing in the opposite direction without the cooling air coming into physical contact with the heated air stream (L1, L3, L5) for cooling in the thin cooling unit, **characterised in that**
(a) separating elements (12a, 12b, 12c; 22a, 22b, 22c) are provided for sealing off the air for cooling in an inflow region (13; 11) and/or in an outflow region (23, 21) and shut off first ducts (k1, k3, k5) for the air (L3) for cooling from second ducts (k2, k4, k6) for the cooled air (L4) and
(b) the separating elements (12a, 22a,...) for shutting the inflow region (11) or outflow region (21) of the air (L3) for cooling off from the cooling air (L4) are disposed in the cooling unit and are completely immersed in the stream of air for cooling and of the cooling air, thus also providing a heat-exchange surface in front of the inflow region and behind the outflow region.

2. A cooling unit according to the preceding claim, wherein webs for closing off a respective chamber are disposed so that they tightly seal thin chambers for the air for cooling at an inflow side (30) and outflow side (40) of the cooling air and tightly seal the thin chambers for the cooling air (KL, L4, AL) at the inflow region and the outflow region for the air (11, 21) for cooling.

3. A cooling unit according to any of the preceding claims, wherein two fans (30, 31; 40, 41, 10) are in the form of axial fans.

4. A cooling unit according to claim 2 or 3, wherein the chambers (k1, k2, k3, k4) are separated from one another by metal sheets (50a, 50b, 50c, ...) and the height (h1, h2, ...) of the chambers is determined by the spacing between the sheets.

5. A cooling unit according to any of the preceding claims, wherein web portions (12, 42, 22, 32) between the sheets (50a, 50b) bounding the flat chambers are provided at the inlet region and the outlet region (13, 23) for the air for cooling or the cooling air and are also provided for closing the chambers not open at the respective place.

6. A cooling unit according to claim 4 or 5, wherein the metal sheets are not flat, or more especially are corrugated or knobbed.

7. A cooling unit according to any preceding claim, wherein shut-off members (28, 18) are provided in the inlet region of the air (SL) for cooling and/or in the outlet region of the cooled air (DL) in order to block any direct flow path between the inlet region and the outlet region and to prolong the distance travelled by the air for cooling in the chambers.

8. A cooling unit according to claim 7, wherein the shut-off members (18, 28) are adjustable.

9. A cooling unit according to claim 7 or 8, wherein the shut-off members are bent.

10. A cooling unit according to any of the preceding claims, wherein the inlet region (13, 11) and/or the outlet region (23, 21) is substantially round or substantially cylindrical in a vertical direction (h) of the cooling unit.

11. A cooling unit according to any of the preceding claims, wherein a third fan (10) is operated at the inlet region (13, 11) of the air (SL) for cooling at a speed which is greater than a speed of a fourth fan (20) at the outlet region of the cooled air (DL, 23), more especially is above 10% of the power of the fourth filter (20).

12. A cooling unit according to any of the preceding claims 1 to 10, wherein a fourth fan is disposed at the outlet region (21, 23) of the cooled air and is weaker than a third fan (10).

13. A cooling unit according to claim 4, wherein the spacing between the metal sheets is determined by webs (12a, 42a, 22a, 32a) and the height (h1, h2) of each chamber corresponds to the respective web height.

14. A method of cooling the air from an instrument locker, server cabinet or switch cabinet or a substantially closed casing arrangement for holding heat-generated equipment, wherein heated air (SL) in counter-current (L4; L3; k₁; k₂ ...) with cooling air (KL) flowing in the opposite direction is reduced in temperature without the cooling air coming into physical contact with the heated air stream (L1, L3, L5) for cooling,
**characterised in that** the cooling air (KL, AL) flows past a cylindrical inlet region (13, 11) for the air stream (SL, L1) for cooling and/or in front of a cylindrical outlet region (21, 23) for the air stream (L5, DL) already cooled in front of and behind the inlet/outlet, in order to have a heat-exchange surface behind or in front of the inlet or outlet.

15. A method according to claim 14, wherein the flow past the inlet region or the flow in front of the outlet region occurs over a width (b1 + b2; b3 + b4) which is not less, more especially is substantially the same or greater, than a width, especially a diameter (d₁₃, d₂₃), of the inflow region (13) or the outflow region (23).

16. A method according to claim 14, wherein the air (L3, L4) for cooling and the cooled air flow in thin extended layers which have a thickness (h₁, h₂) just sufficient to promote turbulent flow in the layers.

17. A method according to claim 16, wherein the layers are less than 10 mm, especially less than 5 mm thick.

18. A method according to claim 14, wherein the heated air (SL) supplied by a third fan (10) is supplied more intensively, more especially at greater power, than the air from a fourth fan (20) which withdraws air cooled in the cooling unit in the outlet region (23, 21) from the cooling unit.

19. A method according to claim 14, wherein a cooling unit according to claim 6 is used.

## Revendications

1. Refroidisseur à surface plate destiné à être utilisé pour des armoires d'appareillage, des armoires de serveurs ou des armoires de commande ou un ensemble boîtier essentiellement fermé pour accueillir des dispositifs générateurs de chaleur, dans lequel la température de l'air réchauffé (SL) peut être abaissée à contre-courant (L4 ; L3 ; k₁ ; k_{2...}) avec de l'air réfrigéré (KL) circulant en sens inverse sans que l'air réfrigéré n'entre physiquement en contact avec le flux d'air (L1, L3, L5) réchauffé à réfrigérer dans le refroidisseur à surface plate, **caractérisé en ce que**,
(a) des éléments de séparation étanches (12a, 12b, 12c ; 22a, 22b, 22c) sont prévus dans une zone d'admission (13, 11) et / ou dans une zone d'évacuation (23, 21) de l'air à réfrigérer, éléments à l'aide desquels des premiers canaux (k1, k3, k5) pour l'air à réfrigérer (L3) sont séparés de seconds canaux (k2, k4, k6) pour l'air réfrigérant (L4) ;
(b) les éléments de séparation étanches (12a, 22a,...) de l'air à réfrigérer (L3) et de l'air réfrigérant (L4) de la zone d'admission (11) ou de la zone d'évacuation (21) sont disposés dans le refroidisseur et peuvent être entièrement exposés au flux d'air réfrigérant et d'air à réfrigérer, une surface d'échange étant ainsi également prévue avant la zone d'admission et après la zone d'évacuation.

2. Refroidisseur selon la revendication précédente, dans lequel des entretoises pour la fermeture d'une chambre correspondante sont disposées de manière à ce qu'elles ferment de façon étanche des chambres à surface plate pour l'air à réfrigérer au niveau d'une face d'admission (30) et d'une face d'évacuation (40) de l'air réfrigéré et ferment de façon étanche les chambres à surface plate pour l'air réfrigéré (KL, L4, AL) au niveau de la zone d'admission et de la zone d'évacuation de l'air à réfrigérer (11, 21).

3. Refroidisseur selon l'une des revendications précédentes, dans lequel deux ventilateurs (30, 31 ; 40, 41, 10) servent de ventilateurs axiaux.

4. Refroidisseur selon l'une des revendications 2 ou 3, dans lequel les chambres (k1, k2, k3, k4) sont séparées les unes des autres par des tôles (50a, 50b, 50c, ...) et où les hauteurs (h1, h2,...) des chambres sont déterminées par l'écart entre les tôles.

5. Refroidisseur selon l'une des revendications précédentes, dans lequel sont prévues des entretoises (12, 42, 22, 32) au niveau de la zone d'admission et de la zone d'évacuation (13, 23) aussi bien de l'air réfrigérant que de l'air à réfrigérer, ces entretoises étant disposées entre les tôles (50a, 50b) délimitant la surface plate des chambres et servant à la fermeture étanche de la chambre non ouverte à l'endroit correspondant.

6. Refroidisseur selon la revendication 4 ou 5, dans lequel, les tôles ne sont pas planes mais sont plus particulièrement ondulées ou noppées.

7. Refroidisseur selon l'une des revendications précédentes, dans lequel dans la zone d'admission de l'air à réfrigérer (SL) et / ou dans la zone d'évacuation de l'air réfrigéré (DL) sont prévus des éléments de blocage (28, 18) afin de bloquer une voie directe de circulation du flux entre la zone d'admission et la zone d'évacuation et de prolonger le cheminement de l'air à réfrigérer dans les chambres.

8. Refroidisseur selon la revendication 7, dans lequel les éléments de blocage (18, 28) sont ajustables.

9. Refroidisseur selon la revendication 7 ou 8, dans lequel les éléments de blocage sont de forme courbée.

10. Refroidisseur selon l'une des revendications précédentes, dans lequel la zone d'admission (13, 11) et/ou la zone d'évacuation (23, 21) sont essentiellement de conception circulaire ou essentiellement de conception cylindrique dans une extension en hauteur (h) du refroidisseur.

11. Refroidisseur selon l'une des revendications précédentes, dans lequel un troisième ventilateur (10) peut être mis en service au niveau de la zone d'admission (13, 11) de l'air à réfrigérer (SL) avec une vitesse de rotation qui est supérieure à la vitesse de rotation d'un quatrième ventilateur (20) au niveau de la zone d'évacuation de l'air réfrigéré (DL, 23), en particulier de plus de 10 % supérieure à la puissance du quatrième ventilateur (20).

12. Refroidisseur selon l'une des revendications 1 à 10, dans lequel un quatrième ventilateur est disposé au niveau de la zone d'évacuation (21, 23) de l'air réfrigéré et dont la puissance est inférieure à celle d'un troisième ventilateur (10).

13. Refroidisseur selon la revendication 4, dans lequel l'écart entre les tôles est déterminé par des entretoises (12a, 42a, 22a, 32a) et dans lequel la hauteur (h1, h2) de chaque chambre correspond à la hauteur des entretoises.

14. Procédé de réfrigération d'air d'une armoire d'appareillage, d'une armoire de serveur ou d'une armoire de commande ou d'un ensemble boîtier essentiellement fermé pour accueillir des dispositifs générateurs de chaleur, dans lequel la température de l'air réchauffé (SL) est abaissée à contre-courant (L4 ; L3 ; k₁; k_{2...}) avec de l'air réfrigéré (KL) circulant en sens inverse sans que l'air réfrigéré n'entre physiquement en contact avec le flux d'air (L1, L3, L5) réchauffé à réfrigérer, **caractérisé en ce que** l'air réfrigéré (KL, AL) circule en passant devant une zone d'admission cylindrique (13, 11) pour le flux d'air à réfrigérer (SL, L1) et / ou avant une zone d'évacuation cylindrique (21, 23) pour le flux d'air déjà réfrigéré (L5, DL) avant et après l'admission / l'évacuation, afin de disposer d'une surface d'échange après ou avant l'admission ou l'évacuation.

15. Procédé selon la revendication 14, dans lequel le passage du flux devant la zone d'admission ou la circulation du flux avant la zone d'évacuation se déroule sur une largeur (b1+b2 ; b3+b4) qui n'est pas inférieure et en particulier qui est essentiellement identique ou supérieure à une largeur, plus précisément à un diamètre (d₁₃, d₂₃) de la zone d'admission (13) ou de la zone d'évacuation (23) du flux.

16. Procédé selon la revendication 14, dans lequel l'air à réfrigérer et l'air réfrigérant (L3, L4) circulent dans des couches à surface plate étendue dont la hauteur (h1, h2) est telle qu'elle favorise une circulation turbulente du flux dans les couches.

17. Procédé selon la revendication 16, dans lequel les couches ont une hauteur inférieure à 10 mm, et en particulier inférieure à 5 mm.

18. Procédé selon la revendication 14, dans lequel l'air réchauffé (SL) introduit à l'aide d'un troisième ventilateur (10) est introduit de façon plus intense, plus précisément avec une puissance plus importante que l'air d'un quatrième ventilateur (20) qui évacue l'air réfrigéré dans le refroidisseur dans la zone d'évacuation (23, 21) hors du refroidisseur.

19. Procédé selon la revendication 14, dans lequel un refroidisseur selon la revendication 6 est utilisé.
